# EUROPÄISCHE PATENTSCHRIFT

(11) **EP 3 341 139 B1**
(45) Veröffentlichungstag und Bekanntmachung des Hinweises auf die Patenterteilung: **18.12.2019**
(21) Anmeldenummer: 16762982.3
(22) Anmeldetag: 24.08.2016
(51) Int. Cl.: B08B 3/10, B08B 7/00, C23C 16/455, H01L 21/67

(54) **VORRICHTUNG ZUM AUFBRINGEN EINES MIT UV-STRAHLUNG BEAUFSCHLAGTEN FLÜSSIGEN MEDIUMS AUF EIN SUBSTRAT**
DEVICE FOR SUPPLYING A FLUID MEDIUM EXPOSED TO AN UV-RADIATION ON A SUBSTRATE
APPAREIL POUR APPLIQUER UN MEDIUM FLUIDEEXPOSÉ À UNE RADIATION UV SUR UN SUBSTRAT

(30) Priorität: 27.08.2015 DE 102015011228
(43) Veröffentlichungstag der Anmeldung: 04.07.2018
(73) Patentinhaber: Süss Microtec Photomask Equipment GmbH & Co. KG, 75447 Sternenfels (DE)
(72) Erfinder: DRESS, Peter, 75447 Sternenfels (DE); DIETZE, Uwe, 75447 Sternenfels (DE); GRABITZ, Peter, 75447 Sternenfels (DE)
(74) Vertreter: Wimmer, Hubert
(86) Internationale Anmeldenummer: PCT/EP2016/069979
(87) Internationale Veröffentlichungsnummer: WO 2017/032801

(56) Entgegenhaltungen:
- EP-A2- 2 496 367
- JP-A- H07 196 303
- JP-A- 2001 300 451
- JP-A- 2008 041 998
- US-A1- 2012 132 618

## Beschreibung

Die vorliegende Erfindung betrifft eine Vorrichtung zum Aufbringen eines mit UV-Strahlung beaufschlagten flüssigen Mediums auf ein Substrat, um das Substrat zu Behandeln, wobei die Flüssigkeit lokal im Bereich der Vorrichtung auf einen Teilbereich des Substrats aufgebracht und UV-Strahlung in die Flüssigkeit eingebracht wird.

In der Halbleitertechnik ist es bekannt, dass beispielsweise Fotomasken sowohl während ihrer Herstellung als auch während Ihres Einsatzes unterschiedlichen Behandlungsschritten, insbesondere Reinigungsschritten ausgesetzt werden müssen. Beispielsweise ist es bekannt, die Fotomasken einer Nassreinigung auszusetzen, bei der wenigstens lokal ein Flüssigkeitsfilm auf dem Substrat erzeugt und in diesen Flüssigkeitsfilm UV-Strahlung eingeleitet wird. Entsprechende Reinigungsschritte sind auch für Halbleiterwafer während ihrer Herstellung bekannt. Dabei sind die Flüssigkeit und die UV-Strahlung so aufeinander abgestimmt, dass ein Großteil der UV-Strahlung in dem Flüssigkeitsfilm absorbiert wird, um Radikale in dem Flüssigkeitsfilm zu erzeugen, welche die Reinigung fördern. Insbesondere ist es bekannt, Hydroxyl-Radikale beispielsweise in verdünntem Wasserstoffperoxydwasser oder Ozonwasser O₃-H₂O zu erzeugen. Solche Hydroxyl-Radikale bewirken eine selektive Lösung von organischen Materialien von der Substratoberfläche, ohne ggf. metallische Schichten auf der Substratoberfläche anzugreifen. Verdünntes Wasserstoffperoxydwasser oder Ozonwasser O₃-H₂O kann aber auch unerwünschte reaktive Spezies enthalten, die nicht auf das Substrat gelangen dürfen.

Eine hierfür geeignete Vorrichtung ist zum Beispiel aus der auf die Anmelderin zurückgehenden DE 10 2009 058 962 A1 bekannt. Insbesondere zeigt diese Anmeldung eine Vorrichtung gemäß dem Oberbegriff des Anspruchs 1.

Ausgehend von dieser Vorrichtung stellt sich die vorliegende Erfindung die Aufgabe eine bessere Vorkonditionierung der Flüssigkeit vor ihrem Aufbringen auf das Substrat vorzusehen. Hierzu weist die Vorrichtung nunmehr zusätzlich die Merkmale des kennzeichnenden Teils der Anspruchs 1 auf.

Insbesondere ist eine Vorrichtung zum Aufbringen eines mit UV-Strahlung beaufschlagten flüssigen Mediums auf ein Substrat vorgesehen, die Folgendes aufweist: ein Gehäuse, mit einer langgestreckten Kammer, wenigstens einer Einlassöffnung, die sich zur Kammer hin öffnet und einer der wenigstens einen Einlassöffnung gegenüberliegenden, schlitzförmigen Auslassöffnung, die sich über die Länge der Kammer erstreckt, ein sich in Längsrichtung durch die Kammer erstreckendes Rohrelement, das wenigstens teilweise für UV-Strahlung transparent ist, wobei das Rohrelement derart in der Kammer angeordnet ist, dass zwischen dem Rohrelement und der Wand der Kammer ein Strömungsraum gebildet wird, der bezüglich einer Längsmittelebene der Kammer, die die Auslassöffnung mittig schneidet, symmetrisch ist, und dass sich das Rohrelement in die schlitzförmige Auslassöffnung im Gehäuse erstreckt und dabei zwei in Längsrichtung erstreckende Austrittsschlitze zwischen Rohrelement und Gehäuse bildet, und wenigstens eine UV-Strahlungsquelle im Rohrelement, die angeordnet ist, um UV-Strahlung in Richtung des Strömungsraumes und durch die Auslassöffnung aus dem Gehäuse heraus zu emittieren. Die Vorrichtung zeichnet sich dadurch aus, dass ferner Mittel vorgesehen sind, die bewirken, dass UV-Strahlung in einem ersten Wellenlängenbereich durch einen ersten Abschnitt des Rohrelements in den Strömungsraum emittiert wird und dass UV-Strahlung in einem zweiten Wellenlängenbereich durch einen zweiten Abschnitt des Rohrelements durch die Austrittsöffnung des Gehäuses und optional in einen Endbereich des Strömungsraums benachbart zu den Austrittsschlitzen, emittiert wird. Die ersten und zweiten Wellenlängenbereiche unterscheiden sich und für wenigstens den zweiten Abschnitt gilt, dass maximal 20%, bevorzugt maximal 5% der durch den zweiten Abschnitt emittierten Strahlungsleistung aus dem ersten Wellenlängenbereich stammt.

Mithin kann in unterschiedlichen Bereichen eine unterschiedliche Strahlung eingeleitet werden, die auf einen bestimmten Zweck zugeschnitten sein kann. So kann beispielsweise in den Strömungsraum primär Strahlung im Wellenlängenbereich unter 200 nm, insbesondere primär im Bereich um 185 nm eingeleitet werden. In diesem Bereich ist die Strahlung besonders geeignet ein flüssiges Medium im Strömungsbereich zu zersetzten, um reaktive Spezies auf- oder auch abzubauen. Beispielsweise kann gezielt (Ozon) abgebaut werden oder zum Beispiel OH aus Wasser erzeugt werden. Hierbei bestimmt die Kombination aus Medium und dem verwendeten Wellenlängenbereich, ob ein Auf- oder Abbau von reaktiven Spezies erfolgt und kann nach Bedarf eingestellt werden. Hingegen kann zum Beispiel im Bereich der Austrittsschlitze und in den außerhalb des Strömungsraum liegenden Bereich (in Richtung eines zu behandelnden Substrats) primär Strahlung im Wellenlängenbereich über 200 nm, insbesondere primär im Bereich um 254 nm eingeleitet werden. In diesem Bereich ist die Strahlung besonders geeignet Radikale in dem flüssigen Medium zu erzeugen. Die hierfür eingesetzten Mittel können unterschiedlichster Natur sein. Bei den obigen Beispielen wurde die Grenze für die Wellenlängenselektion bei 200 nm gesetzt. Es können aber auch andere Grenzen oder Bereich unterschiedlicher Wellenlängen eingestellt werden. Dies gilt im Übrigen auch für die nachfolgenden Beispiele und die gesamte Offenbarung. Insbesondere wird eine Vorkonditionierung einer Flüssigkeit durch Bestrahlung mit einem ersten Wellenlängenbereich (im Einlassbereich) und eine anschließende Bestrahlung mit einem zweiten Wellenlängenbereich (im Auslass Bereich) dieser vorkonditionierten Flüssigkeit zur weiteren Erzeugung von Radikalen ermöglicht. Somit ergibt sich ein zweistufiger Prozess, der "automatisch" in Flussrichtung der Flüssigkeit abläuft.

Bei einer Ausführungsform weisen die Mittel verschiedene Materialien mit unterschiedlichen Transmissionseigenschaften für die jeweiligen Wellenlängenbereiche auf, die die Transmissionseigenschaften der ersten und zweiten Abschnitte des Rohrelements beeinflussen. So kann zum Beispiel ein erster, oberer Abschnitt des Rohrelements (der den Strömungsraum wenigstens teilweise begrenzt) für UV-Strahlung im Bereich über 200 nm primär undurchlässig sein (weniger als 50% der Strahlung in diesem Wellenlängenbereich treten durch das Rohrelement hindurch), für UV-Strahlung im Bereich unter 200 nm hingegen im Wesentlichen transparent. In gleicher Weise könnte ein zweiter unterer Abschnitt, der sich wenigstens teilweise aus dem Gehäuse heraus erstreckt, für UV-Strahlung im Bereich unter 200 nm primär undurchlässig sein (weniger als 50% der Strahlung in diesem Wellenlängenbereich treten durch das Rohrelement hindurch), für UV-Strahlung im Bereich über 200 nm hingegen im Wesentlichen transparent. Der Winkelbereich der jeweiligen Abschnitte kann in einem beliebigen geeigneten Bereich liegen, und es ist auch möglich, weitere Abschnitte mit noch anderen Transmissionseigenschaften vorzusehen. So können zum Beispiel in einem Einleitungsbereich des Mediums die Transmissionseigenschaften so sein, dass im Wesentlichen gar keine Strahlung austritt, da das Medium hier noch inhomogen strömt und ein entsprechender Effekt nicht homogen auftreten würde.

Die Transmissionseigenschaften der Abschnitte des Rohrelements können beispielsweise durch die Materialwahl des Rohrelements selbst eingestellt werden. So ist zum Beispiel normales Glas für UV licht absorbierend, Quarzglas hingegen im UV Spektralbereich transparent. Es können aber beispielsweise auch selektiv reflektierende oder absorbierende Materialen zum Beispiel in Form von Schichten und/oder Folien auf oder benachbart zu den jeweiligen Abschnitten des Rohrelements vorgesehen werden.

Bei einer Ausführungsform weisen die Mittel wenigstens zwei unterschiedliche UV-Strahlungsquellen und wenigstens ein Trennelement in dem Rohrelement auf, das zwischen den unterschiedlichen UV-Strahlungsquellen angeordnet ist, wobei wenigstens eine erste Strahlungsquelle Strahlung primär im ersten Wellenlängenbereich und wenigstens eine zweite Strahlungsquelle Strahlung primär im zweiten Wellenlängenbereich emittiert. Primär bezeichnet hier und auch sonst in der Anmeldung wenigstens 80 % und die Angaben sind auf die Intensität der Strahlung im jeweiligen Wellenlängenbereich bezogen. Bevorzugt erstreckt sich das Trennelement im Wesentlichen über die gesamte Breite des Rohrelements und die Enden des Trennelements definieren eine Trennung zwischen den ersten und zweiten Abschnitten des Rohrelements. Die den jeweiligen Strahlungsquellen zugewandten Oberflächen des Trennelements können wenigstens teilweise spiegelnd ausgebildet sein und zwar insbesondere spiegelnd für den jeweiligen primären Emissionsbereich der zugewandten Strahlungsquelle. Hierdurch kann die Ausbeute der Strahlung in dem jeweiligen Wellenlängenbereich in den ersten und zweiten Abschnitten erhöht werden

Um eine bestimmte räumliche Intensitätsverteilung, der durch die jeweiligen Abschnitte emittierte Strahlung zu erreichen, kann wenigstens eine der jeweils der Strahlungsquellen zugewandte Oberfläche des Trennelements gebogen sein, um an der Oberfläche reflektierte Strahlung in einem bestimmten Muster zu verteilen. Insbesondere in dem sich aus dem Strömungsraum heraus erstreckenden Abschnitt kann eine solche räumliche Verteilung von Vorteil sein, da sie die Verteilung der Radikalen auf der Oberfläche eines zu behandelnden Substrats beeinflussen kann. Insbesondere lässt sich gegebenenfalls ein Bereich hoher Radikalenkonzentration verbreitern. Beispielsweise kann die der ersten Strahlungsquelle zugewandte Oberfläche des Trennelements konvex gebogen sein und/oder die der zweiten Strahlungsquelle zugewandte Oberfläche wenigstens einen konkav gebogenen Abschnitt aufweisen, um eine gewünschte Strahlungsverteilung vorzusehen.

Bei einer Ausführungsform weisen die Mittel im Rohrelement und benachbart zu oder in Kontakt mit wenigstens einem Abschnitt des Rohrelements ein Filterelement auf, das selektiv UV-Strahlung im gewünschten Wellenlängenbereich durchlässt und Strahlung außerhalb des gewünschten Wellenlängenbereichs absorbiert. Dabei kann der erste Wellenlängenbereich beispielsweise im Bereich von <200 nm und der zweite Wellenlängenbereich im Bereich von > 220 nm liegt.

Vorteilhafterweise können ferner zweite Mittel vorgesehen sein, die bewirken, dass in einem dritten Abschnitt des Rohrelements, der zum Strömungsraum weist, keine UV-Strahlung in den Strömungsraum emittiert wird. Beispielsweise können die zweiten Mittel ein für UV-Strahlung opakes Element zwischen der wenigstens einen Strahlungsquelle und dem Strömungsraum aufweisen. Der dritte Abschnitt würde bevorzugt zur wenigstens einen Einlassöffnung weisen, zur Längsmittelebene symmetrisch angeordnet sein und sich in Umfangsrichtung des Rohrelements bis maximal 5° vor die entsprechenden Austrittsschlitze erstrecken.

Der zweite Abschnitt kann optional im Bereich der Austrittsschlitze auch Strahlung in den Strömungsraum emittieren und diesen insofern überlappen. Dabei ist ein Überlapp auf das letzte Viertel der Entfernung zwischen der einen Einlassöffnung und dem jeweiligen Austrittsschlitz begrenzt, wobei die Entfernung entlang der Strömungsrichtung an einer Innenfläche des Strömungsraums gemessen wird.

Der zweite Abschnitt deckt von einem Mittelpunkt des Rohrelements aus gesehen wenigstens einen Winkelbereich ab, der einem vom Mittelpunkt des Rohrelements aus gesehenem Winkelbereich der schlitzförmigen Öffnung im Gehäuse entspricht. Mit anderen Worten deckt der Winkelbereich wenigstens den Bereich der schlitzförmigen Öffnung im Gehäuse ab. Hierdurch wird sichergestellt, dass aus der Öffnung im Gehäuse im Wesentlichen nur Strahlung des zweiten Wellenlängenbereichs emittiert wird. Der zweite Abschnitt kann einen Winkelbereich abdecken, der bis maximal 40° größer ist als der vom Mittelpunkt des Rohrelements aus gesehenem Winkelbereich der schlitzförmigen Öffnung im Gehäuse. Mit anderen Worten überlappt der zweite Abschnitt auch noch den Bereich des Strömungsraum der zwischen dem Rohrelement und der Wand der Kammer gebildet wird, und zwar ausgehend vom Austrittsschlitz um maximal 20° in jede Richtung. Hierdurch können zum Beispiel auch schon in den Endbereichen des Strömungsraums vor dem Austritt der Flüssigkeit Radikale erzeugt werden.

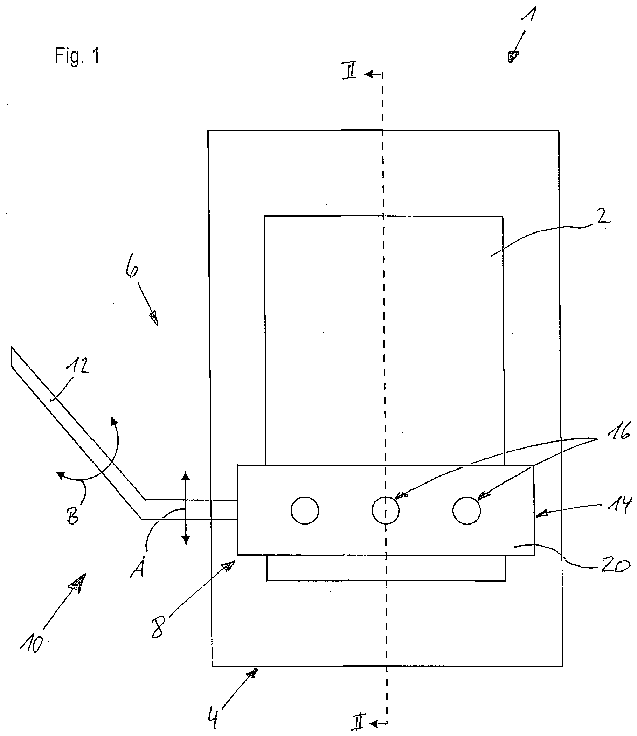

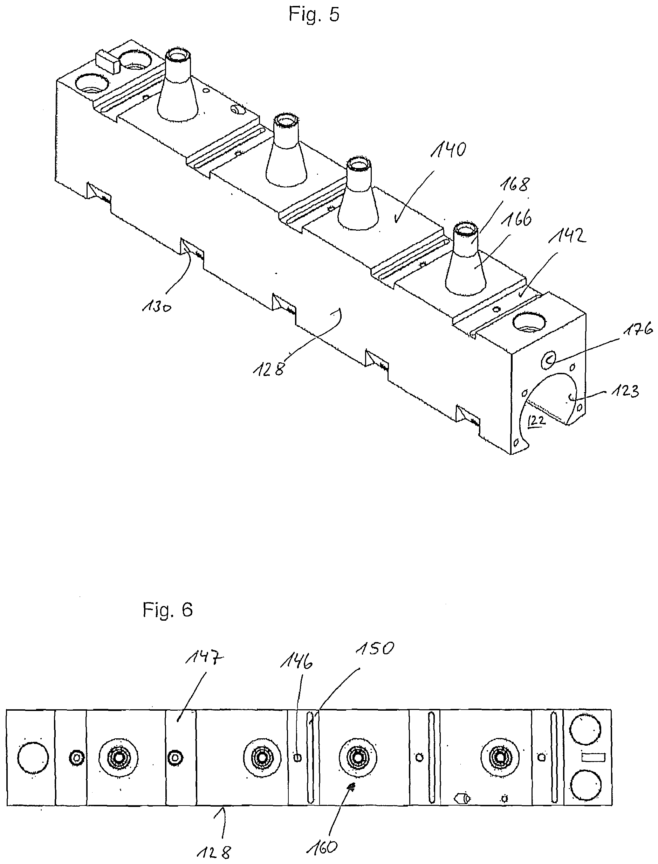

Die Erfindung wird nachfolgend unter Bezugnahme auf die Zeichnungen näher erläutert. Da die in Bezug auf die Abb. 1-9 beschriebenen Ausführungsformen keine Mittel wie die in Anspruch 1 definierten Mittel offenbaren, stellen sie keine Ausführungsformen der Erfindung dar. Die Erfindung ist durch den Anspruch 1 definiert.

In den Zeichnungen zeigt:
- Fig. 1: eine schematische Draufsicht auf eine Substrat-Behandlungsvorrichtung mit einer Vorrichtung zum Aufbringen eines mit UV-Strahlung beaufschlagten flüssigen Mediums auf ein Substrat;
- Fig. 2: eine schematische Schnittansicht durch die Vorrichtung entlang der Linie II-II in Fig. 1;
- Fig. 3: eine schematische Schnittansicht entlang der Linie III-III in Fig. 4, die ähnlich zur Fig. 2 ist aber eine alternative Ausführungsform zeigt;
- Fig. 4: eine schematische Längsschnittansicht durch ein Gehäuse der alternativen Ausführungsform der Erfindung gemäß Fig. 3 entlang der Linie IV-IV in Fig. 3;
- Fig. 5: eine schematische perspektivische Ansicht des Gehäuses gemäß Fig. 4;
- Fig. 6: eine schematische Draufsicht auf das Gehäuse gemäß Fig. 4;
- Fig. 7: eine schematische Vorderansicht eines Klemmbügels;
- Fig. 8 a und b,: schematische horizontale Schnittdarstellungen, im Bereich von Austrittsschlitzen der Vorrichtung, welche den Effekt von Klemmbügeln erläutern;
- Fig. 9 a bis c: schematische Schnittdarstellungen durch unterschiedliche Konfigurationen eines Strahlungsteils der Vorrichtung, wobei Fig. 9 a eine Normalkonfiguration zeigt, und die Fig. 9b und 9c alternative Konfigurationen zeigen;
- Fig. 10 a bis c: schematische Schnittdarstellungen von weiteren Ausführungsalternativen;
- Fig. 11: eine schematische Schnittansicht durch eine weitere alternative Konfiguration des Strahlungsteils;
- Fig. 12: eine schematische Schnittansicht ähnlich Fig. 11 einer weiteren Konfiguration des Strahlungsteils.

In der nachfolgenden Beschreibung verwendete Richtungsangaben, wie oben oder unten, links oder rechts, beziehen sich auf die Darstellung in den Figuren und ist in keiner Weise einschränkend, obwohl es sich auch um bevorzugte Anordnungen handeln kann. In der nachfolgenden Beschreibung ist der Begriff "Bohrung" als sich längs erstreckende Sack- oder Durchgangsöffnung zu verstehen, die unabhängig von der Art der Herstellung ist, d.h. sie muss nicht durch den Vorgang des Bohrens hergestellt sein, sondern kann in beliebiger geeigneter Weise hergestellt werden.

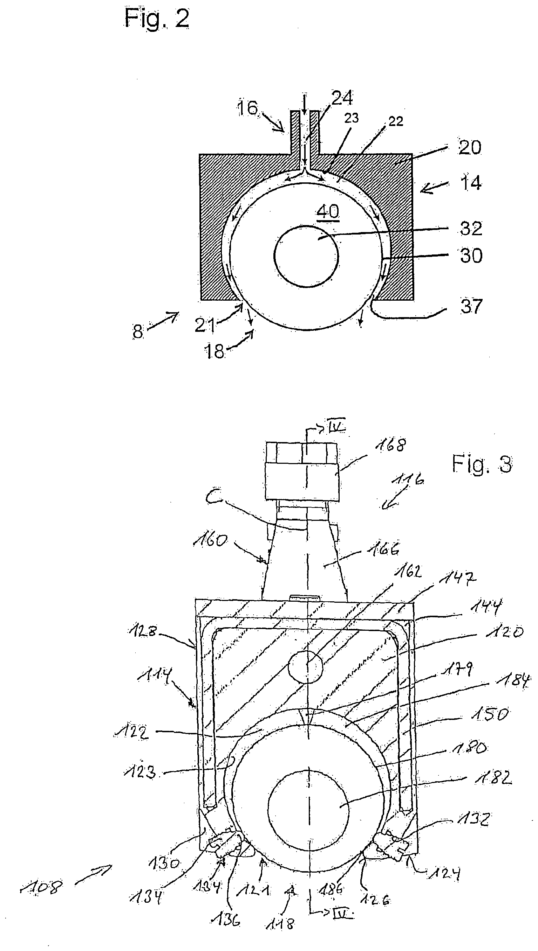

Fig. 1 zeigt eine schematische Draufsicht auf eine Vorrichtung 1 für eine durch UV-Strahlung unterstützte Nassbehandlung von Substraten 2, insbesondere Masken oder Halbleiterwafern für die Chipherstellung, wobei das Substrat aber auch eines der Folgenden sein kann: eine Photomaske für die Herstellung von Halbleiterwafern, ein Halbleiterwafer, insbesondere ein Si-Wafer, Ge-Wafer, GaAs-Wafer, InP-Wafer, ein Flat panel Substrat, ein Multi-Layer Ceramic Substrat. Fig. 2 zeigt eine schematische Schnittansicht durch die Vorrichtung 1 entlang der Linie II-II. Die Vorrichtung 1 besteht im Wesentlichen aus einer Substrataufnahme 4 und einer Auftragseinheit 6. Die Substrataufnahme 4 und die Auftragseinheit 6 können in einer nicht dargestellten Druckkammer aufgenommen sein, in der über geeignete Mittel ein Überdruck oder auch ein Unterdruck erzeugt werden kann.

Dabei ist zu beachten, dass bei einer Nassbehandlung eine Flüssigkeit, wie beispielsweise verdünntes Wasserstoffperoxydwasser oder Ozonwasser O₃-H₂O oder auch andere insbesondere Wasser enthaltende Flüssigkeiten auf das Substrat aufgebracht werden. Bei einer UV-Bestrahlung der Flüssigkeit treten komplexe Reaktionen auf und allein bei Wasser als Flüssigkeit entstehen beispielsweise 14 unterschiedliche Spezies, wie zum Beispiel H₂O, H^{•}. HO^{•}, e-aq, HO₂^{•}, O₂^{•-}, H₂, O₂, H₂O₂, H₂O⁻, H₃O⁺, HO⁻, O₃^{•-} und HO₃^{•}. Solche Reaktionen sind wesentlich komplexer und Radikale haben wesentlich kürzere Lebenszeiten als in Gasen, die mit UV-Strahlung beaufschlagt werden und daher ist eine Nassbehandlungsvorrichtung nicht ohne weiteres mit einer Behandlungsvorrichtung, die Gase einsetzt, vergleichbar. Die auftretenden Reaktionen sind wellenlängenabhängig und können durch eine Wellenlängenselektion in bestimmte Richtungen beeinflusst werden.

Die Substrataufnahme 4 ist, wie in der Fig. 1 angedeutet ist, als eine flache rechteckige Platte zum Aufnehmen des ebenfalls rechteckigen Substrats 2 dargestellt. Die Substrataufnahme 4 kann aber auch unterschiedliche Formen annehmen und an die Form eines zu behandelnden Substrats 2 angepasst sein. Die Substrataufnahme 4 besitzt wenigstens einen nicht dargestellten Ablauf für flüssige Medien, die über die Auftragseinheit 6 auf das Substrat 2 aufgebracht werden können.

Die Auftragseinheit 6 besteht aus einem Hauptteil 8 und einem Tragteil 10, der den Hauptteil 8 beweglich trägt, wie durch die Doppelpfeile A und B angezeigt ist. Insbesondere besteht der Tragteil 10 aus einem Tragarm 12, der an einem Ende mit dem Hauptteil 8 verbunden ist und dessen anderes Ende mit einem nicht dargestellten Antrieb verbunden ist. Wie durch die Doppelpfeile A und B gezeigt ist, kann der Antrieb beispielsweise eine Schwenkbewegung des Tragarms 10 und somit des Hauptteils 8 und/oder eine Linearbewegung vorsehen. Hierdurch kann der Hauptteil 8 in gewünschter Weise über ein auf der Substrataufnahme 4 aufgenommenes Substrat 2 hinweg bewegt werden, um eine Behandlung von Teilbereichen desselben oder auch der gesamten Oberfläche zu ermöglichen. Darüber hinaus ist es auch möglich, dass der Tragarm 10 eine Hubbewegung durchführt, um einen Abstand des Hauptteils 8 zur Oberfläche eines sich auf der Substrataufnahme 4 befindlichen Substrats 2 einstellen zu können.

Ferner ist es alternativ oder auch zusätzlich möglich einen Bewegungsmechanismus für die Substrataufnahme 4 vorzusehen, um eine Relativbewegung zwischen Substrat 2 und Hauptteil 8 vorsehen zu können.

Der Hauptteil 8 besteht im Wesentlichen aus einem Gehäuse 14, Medienanschlüssen 16 und einem Strahlungsteil 18. Das Gehäuse 14 besitzt einen langgestreckten quaderförmigen Körper 20 aus einem geeigneten Kunststoff, wie beispielsweise TFM, einem modifizierten PTFE. Das Gehäuse kann aber auch aus einem anderen geeigneten Material bestehen. Dabei ist das Material so zu wählen, dass es bei den eingesetzten Temperaturen und Medien beständig ist. In dem Körper 20 ist eine sich in Längsrichtung erstreckende Kammer 22 definiert, die sich über die gesamte Länge durch den Körper 20 erstreckt. An den Längsenden des Körpers 20 sind nicht dargestellt Abdeckelemente anbringbar, um die Kammer 22 in Längsrichtung zu begrenzen. Der Körper 20 und somit die Kammer 22 besitzen eine Länge, die größer ist als eine Breitenabmessung des Substrats 2, um dieses über die gesamte Breite hinweg mit einem flüssigen Medium beaufschlagen zu können, wie nachfolgend noch näher erläutert wird. Es ist aber auch möglich, dass der Körper 20 oder die Kammer 22 kleinere Abmessung besitzt. Die Innenwand 23 der Kammer kann so ausgebildet sein, dass sie insbesondere für UV-Strahlung eine hohe Reflektivität aufweist, IR-Strahlung hingegen im Wesentlichen absorbiert.

Die Kammer 22 besitzt einen im Wesentlichen runden Querschnitt, wobei sich die Kammer 22 zur Unterseite des Körpers 20 hin öffnet, so dass der Köper 20 hier eine nach unten (zum Substrat 2) weisende Öffnung 21 definiert. Mithin beschreibt die Innenwand 23 der Kammer 22 im Schnitt lediglich einen Teilkreis, der größer als ein Halbkreis ist, und bevorzugt im Bereich von 250° bis 300°, insbesondere zwischen 270° und 290°, liegt.

Im oberen Bereich der Kammer 22 ist in dem Körper 20 wenigstens eine mit dem Anschluss 16 in Strömungsverbindung stehende Zuleitung 24 vorgesehen, die der Öffnung 21 direkt gegenüber liegt. Die Zuleitung 24 steht mit der Kammer 22 in Strömungsverbindung, um ein flüssiges Medium in die Kammer 22 leiten zu können, wie nachfolgend noch näher erläutert wird.

In der Draufsicht gemäß Fig. 1 sind drei Anschlüsse 16 gezeigt, die jeweils über eine entsprechende Zuleitung 24 mit der Kammer 22 in Strömungsverbindung stehen können. Es kann aber auch eine größere oder kleinere Anzahl von Anschlüssen vorgesehen sein. Über die Anschlüsse 16 kann ein einzelnes flüssiges Medium in die Kammer 22 geleitet werden, oder auch mehrere Medien, die gleichzeitig oder auch sequentiell eingeleitet werden können. Insbesondere ist es möglich unterschiedliche Medienquellen mit den Anschlüssen 16 zu verbinden, über die beispielsweise gleichzeitig unterschiedliche Medien zum jeweiligen Anschluss 16 geleitet werden können, um eine in-situ Mischung zu erzeugen. Als Medien kommen hier insbesondere Flüssigkeiten in Betracht, es können aber auch Gase zugeleitet werden, die zum Beispiel mit einer Flüssigkeit im Anschluss 16 und der Zuleitung 24 vermischt werden, bevor sie in die Kammer 22 eingeleitet werden.

Der Strahlungsteil 18 wird im Wesentlichen durch ein Rohrelement 30 und wenigstens eine Strahlungsquelle 32 gebildet. Das Rohrelement 30 besitzt eine langgestreckte Form und erstreckt sich entlang der gesamten Kammer 22 und kann sich ggf. auch durch (oder in) die nicht dargestellten Abdeckelemente an den Enden des Körpers 20 erstrecken. Das Rohrelement 30 ist aus einem für UV-Strahlung im Wesentlichen transparenten Material und besitzt einen runden Querschnitt. Der Mittelpunkt des im Querschnitt runden Rohrelements 30 ist bezüglich des Mittelpunkts des Teilkreises der Innenwand 23 der Kammer 22 in Richtung der Öffnung 21 versetzt und erstreckt sich teilweise durch die Öffnung 21 aus dem Gehäuse 14 heraus, wie in Fig. 2 dargestellt ist.

Zwischen dem Rohrelement 30 und der Innenwand 23 der Kammer 22 wird somit ein Strömungsraum gebildet. Der Strömungsraum ist bezüglich einer Längsmittelebene C der Kammer 22 (siehe Linie IV-IV in Fig. 3), die die Auslassöffnung 21 und die Zuleitung 24 mittig schneidet, symmetrisch und bildet einen rechten und einen linken Ast, wie in der Querschnittsansicht in Fig. 2 zu erkennen ist. Jeder der Äste besitzt am unteren Ende einen Austrittsschlitz 37, der zwischen Rohrelement 30 und dem jeweiligen Ende der Innenwand 23 im Bereich der Öffnung 21 gebildet wird. Ausgehend von der Zuleitung 24 zum jeweiligen Austrittsschlitz 37 weist jeder der Äste des Strömungsraums einen sich verjüngenden Strömungsquerschnitt auf. Insbesondere verjüngt sich der Strömungsquerschnitt des Strömungsraums in jedem Ast kontinuierlich in Richtung des jeweiligen Austrittsschlitzes 37. Das Verhältnis des Strömungsquerschnitts des Strömungsraums im Bereich benachbart zur wenigstens einen Zuleitung 24 und an den Austrittsschlitzen 37 liegt im Bereich von 10:1 bis 40:1 und bevorzugt im Bereich 15:1 bis 25:1. In Richtung der Austrittsschlitze 37 strömende Medien werden daher wesentlich beschleunigt. Eine entsprechende Beschleunigung der Medien führt einerseits zu einer Homogenisierung der Strömung und andererseits zu hohen Strömungsgeschwindigkeiten an den Austrittsschlitzen 37. Diese Fördern die Ausbildung eines im Wesentlichen kontinuierlicher Vorhangs des flüssigen Mediums unterhalb der Öffnung 21, der zur Ausbildung eines Flüssigkeitsfilms auf ein darunter angeordnetes Substrat 2 verwendet werden kann.

In Fig. 2 sind Strömungspfeile angedeutet, die eine Strömung eines flüssigen Mediums von dem Anschluss 16 über die Zuleitung 24 und die Kammer 22 aus dem Gehäuse 14 heraus zeigen.

Die Strahlungsquelle 32 ist in der dargestellten Konfiguration eine stabförmige Lampe, die mittig innerhalb des Rohrelements 30 angeordnet ist. Die stabförmige Lampe 32 erstreckt sich wiederum über die gesamte Länge der Kammer 22, um eine gleichmäßige Strahlungsverteilung über die Länge der Kammer 22 vorzusehen. Die Strahlungsquelle 32 emittiert primär UV-Strahlung in einem gewünschten Spektralbereich, wobei die emittierte Strahlung sowohl in den Strömungsraum der Kammer 22 hinein als auch durch die Öffnung 21 aus dem Gehäuse 14 heraus emittiert wird. Dabei kann die Strahlung speziell für einen bestimmten Zweck ausgewählt werden, wie nachfolgend noch näher erläutert wird. Die Strahlung kann auch so gesteuert werden, dass in den Strömungsraum unterschiedliche Strahlung emittiert wird als aus der Öffnung 21 heraus.

Statt oder zusätzlich zu einer solchen rohrförmigen Strahlungsquelle können auch noch andere Strahlungsquellen vorgesehen werden, wie zum Teil in nachfolgenden Ausführungsbeispielen dargestellt ist. Insbesondere können innerhalb des Rohrelements 30 mehr als eine Strahlungsquelle 32 vorgesehen sein. Als Strahlungsquelle 32 können zum Beispiel Gasentladungslampen, aber auch LED's oder andere geeignete Lichtquellen, die in einem gewünschten Spektralbereich (wenigstens auch im UV-Bereich) emittieren, eingesetzt werden.

Der zwischen dem Rohrelement 30 und der Strahlungsquelle 32 entstehende Raum 40 kann mit einem Kühlmedium, insbesondere einem gasförmigen Kühlmedium durchströmt werden, um eine Überhitzung der Elemente zu vermeiden. Dabei ist das Kühlmedium so zu wählen, dass es im Wesentlichen keine UV-Strahlung absorbiert.

Anhand der Figuren 3 bis 8 wird nun eine weitere Ausführungsform einer Auftragseinheit 6, insbesondere eines alternative Hauptteils 108, der in der Vorrichtung gemäß Fig. 1 eingesetzt werden kann, beschrieben. Der Hauptteil 108 besteht im Wesentlichen aus einem Gehäuse 114, einer Medienführung 116 und einem Strahlungsteil 118.

Das Gehäuse 114 besitzt wiederum einen langgestreckten, quaderförmigen Körper 120 aus einem geeigneten Material (wie beispielsweise TFM), der eine sich in Längsrichtung erstreckende Kammer 122 aufweist, die sich über die gesamte Länge des Körpers 120 erstreckt. An den Längsenden des Körpers 120 sind nicht dargestellte Abdeckelemente zum Begrenzen der Kammer 122 in Längsrichtung anbringbar, beispielsweise durch Schrauben, die eine lösbare Verbindung vorsehen. Es sind aber auch andere bevorzugt lösbare Verbindungen möglich. Die Kammer 122 kann wiederum eine Länge besitzen, die größer ist als eine Breitenabmessung eines Substrats 2, das mit einem flüssigen Medium beaufschlagt werden soll.

Die Kammer 122 besitzt wiederum einen im Wesentlichen runden Querschnitt, wobei sich die Kammer 122 zu einer Unterseite 124 des Körpers 120 hin öffnet, so dass eine nach unten weisende Öffnung 121 definiert wird. Eine Innenwand 123 der Kammer 122 beschreibt somit wieder einen Teilkreis, der jedoch größer als ein Halbkreis ist. Dabei liegt der Öffnungswinkel der Öffnung 121 vorzugsweise in einem Bereich zwischen 60° und 120°, insbesondere zwischen 70° und 90°.

Die Unterseite 124 des Körpers 120 ist derart konfiguriert, dass sie eine zu Seitenwänden 128 des Körpers 120 ansteigende Schräge bildet. Zwischen der Schräge und der Öffnung 121 wird ein im Wesentlichen ebener Bereich gebildet, und direkt benachbart zur Öffnung 121 weist der Körper 120 eine Rundung 126 auf. Diese Rundung verbindet den im Wesentlichen ebenen Teil der Unterseite 124 mit der runden Innenwand 123 der Kammer 122 und definiert an ihrem Höhepunkt die eigentliche Öffnung 121 im Körper 120.

Im Übergangsbereich zwischen der Unterseite 124 und Seitenwänden 128 des Körpers 120 ist eine Vielzahl von schrägen Ausnehmungen (z.B. 5 auf jeder Seite, wie dargestellt) vorgesehen. Im Bereich dieser Ausnehmungen 130 weist der Körper 120 jeweils eine Durchgangsbohrung 132 zur Kammer 122 auf. Die Durchgangsbohrung 132 ist gestuft ausgebildet und besitzt einen breiteren zur Ausnehmung 130 weisenden Bereich sowie einen schmaleren zur Kammer 122 weisenden Bereich. In dem breiteren zur Ausnehmung 130 weisenden Bereich ist die Durchgangsbohrung 132 mit einem Innengewinde versehen. Die jeweilige Durchgangsbohrung 132 dient zur Aufnahme eines Stellelements 134, das eine der Durchgangsbohrung 132 entsprechende, gestufte Form mit einem Kopfteil 136 und einem Stellteil 138 aufweist. Der Kopfteil 136 ist so bemessen, dass er durch den schmalen Bereich der Durchgangsöffnung 132 hindurch passt, um in die Kammer 122 hineinragen zu können. Der Stellteil 138 weist ein Außengewinde auf, das mit dem Innengewinde im breiten Teil der Durchgangsöffnung 132 in Eingriff bringbar ist, um dort hinein geschraubt zu werden. Dabei bestimmt die Einschraubtiefe des Stellteils 138, wie weit der Kopfteil 136 des Stellelements 134 in die Kammer 122 hinein ragt. Das Stellelement 134 ist aus einem geeigneten Material hergestellt, dass bei den eingesetzten Temperaturen und Medien beständig ist und kann eine gewisse Elastizität aufweisen. Insbesondere hat sich ein PFA-Material (Polyfluoralkoxyl-Polymer-Material) als geeignet erwiesen. Es können aber auch anderer Materialien, insbesondere andere Kunststoffe eingesetzt werden.

Eine Oberseite 140 des Körpers 120 weist eine Vielzahl von sich - quer zur Längsrichtung des Körpers 120 erstreckende - Ausnehmungen 142 auf, die in Längsrichtung des Körpers 120 mit den Ausnehmungen 130 ausgerichtet sind. Im Bereich jeder Ausnehmung 142 ist jeweils eine weitere Ausnehmung 144 sowie eine Gewindebohrung 146 vorgesehen. Die Gewindebohrung 146 dient zur Aufnahme einer Schraube, über die eine Abdeckplatte 147 zum Ausfüllen der Ausnehmung 142 befestigt werden kann.

Die Ausnehmung 144 besitzt einen ersten Abschnitt, der sich am Boden der Ausnehmung 142 quer zur Längsrichtung des Körpers 120 erstreckt. Die Ausnehmung 144 besitzt ferner jeweils direkt benachbart zu den jeweiligen Seitenwänden 128 einen sich parallel zu den Seitenwänden 128 erstreckenden in die Tiefe gehenden Abschnitt. Die Ausnehmung 144 bildet somit im Wesentlichen eine U-Form, wie am besten in Figur 3 zu erkennen ist.

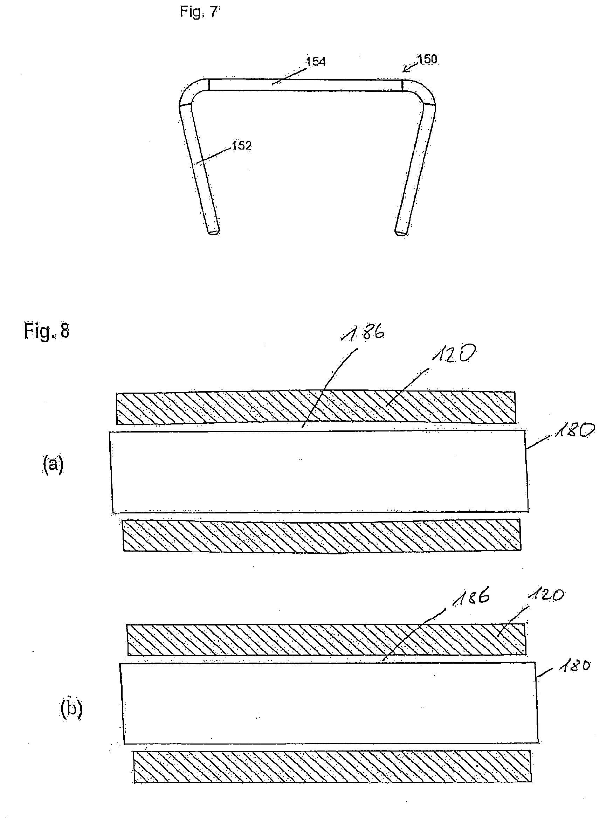

Diese Ausnehmung 144 dient zur Aufnahme eines Klammerelements 150, wie am besten in Figur 3 zu erkennen ist. Figur 7 zeigt eine perspektivische Ansicht des Klammerelements 150 in einem nicht eingebauten und somit entspannten Zustand. Das Klammerelement 150 besitzt im Wesentlichen eine U-Form, wobei sich (im entspannten Zustand) Schenkel 152 des U-förmigen Klammerelements 150 ausgehend von einem Basisteil 154 des Klammerelements 150 zueinander erstrecken, ohne sich zu berühren. Mit anderen Worten ist der Abstand der freien Enden der Schenkel 152 kleiner als der Abstand der Schenkel am Basisteil 154. Wenn die Schenkel 152 des Klammerelements 150 in die U-förmige Ausnehmung 144 eingeführt werden, müssen sie somit leicht auseinander gebogen werden, und sie üben dann eine nach innen gerichtete Vorspannung auf den bezüglich der Schenkel innen liegenden Teil des Körpers 120 aus. Insbesondere wird eine nach Innen gerichtete Vorspannung im Bereich der Stellelemente 134 vorgesehen.

Die zuvor erwähnte Medienführung 116 ist integral im Körper 120 ausgebildet, und wird nachfolgend näher erläutert. Die Medienführung 116 teilt sich im Wesentlichen in Zuleitungselemente 160, einen Medienverteilungskanal 162 sowie Einleitungskanäle 164 auf.

Bei der dargestellten Ausführungsform sind vier Zuleitungselemente 160 vorgesehen, die in Längsrichtung des Körpers 120 voneinander beabstandet sind. Die Zuleitungselemente 160 sind dabei nicht gleichmäßig beabstandet. Vielmehr ist der Abstand zwischen den mittleren Zuleitungselementen 160 kleiner als zu ihren jeweils außen liegenden Zuleitungselementen 160. Die Zuleitungselemente 160 sind jeweils an der Oberseite 140 des Körpers 120 ausgebildet und besitzen jeweils im Wesentlichen einen kegelstumpfförmigen Abschnitt 166, der sich von der Oberseite 140 nach oben erstreckt. Oberhalb des kegelstumpfförmigen Abschnitts 166 ist ein ringförmiger Anschlussteil 168 vorgesehen, der in geeigneter Weise zur Verbindung mit einer externen Zuleitung geeignet ist. Im kegelstumpfförmigen Teil 166 ist eine sich vertikal erstreckende Durchgangsbohrung 170 ausgebildet. Diese erstreckt sich vollständig durch den kegelstumpfförmigen Teil 166 des Zuleitungselements 160, zum Medien-Verteilungskanal 162, der nachfolgend näher erläutert wird.

Der Medienverteilungskanal 162 wird durch eine in Querrichtung des Körpers 120 mittig liegende Längsbohrung 174 gebildet. Die Längsbohrung 174 erstreckt sich vollständig durch den Körper 120 hindurch und ist zwischen der Oberseite 140 und der Kammer 122 angeordnet. In den Endbereichen weist die Längsbohrung 174 jeweils einen verbreiterten Bereich 176 auf, der über geeignete nicht näher dargestellte Endkappen verschlossen werden kann. Der eigentliche Medienverteilungskanal 162 wird nur durch den mittleren, nicht verschlossenen Teil der Längsbohrung 174 gebildet. Wie der Fachmann erkennen kann, wäre es natürlich auch möglich, dass sich die Längsbohrung 174 nur zu einem Ende des Körpers 120 hin öffnet und entsprechend nur an diesem Ende eine Verbreiterung 176 aufweist, die in geeigneter Weise verschlossen werden kann.

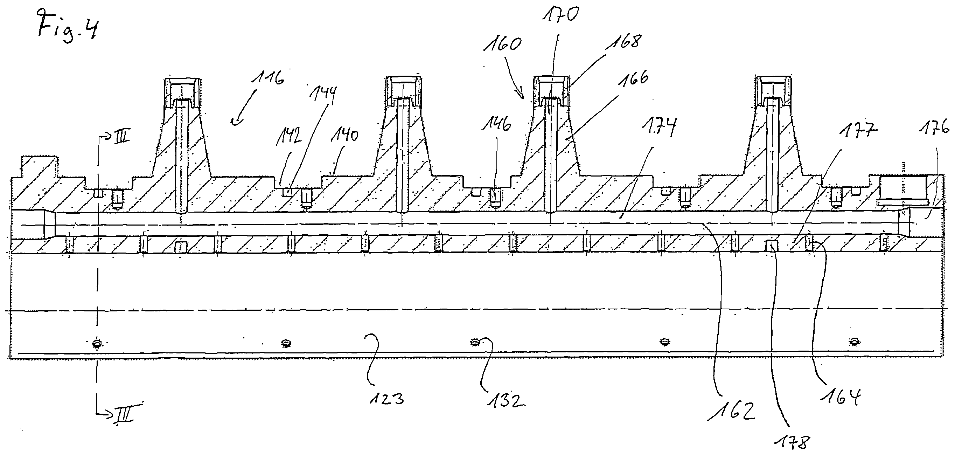

Wie insbesondere in Figur 4 zu erkennen ist, steht die Längsbohrung 174, die den Medienverteilungskanal 162 bildet, an vier Stellen mit den Bohrungen 170 in Strömungsverbindung. Über die. Zuleitungselemente 160 eingeleitetes Medium kann somit an verschiedenen Stellen in den Medienverteilungskanal 162 eingeleitet werden und sich dann in Längsrichtung des Körpers 120 innerhalb des Medienverteilungskanals 162 verteilen.

In einem Wandelement 177 zwischen dem Medienverteilungskanal 162 und der Kammer 122 ist eine Vielzahl von Durchgangsbohrungen ausgebildet, die den Medienverteilungskanal 162 und die Kammer 122 strömungstechnisch verbinden und somit die Einleitungskanäle 164 bilden. In der dargestellten Ausführungsform sind zwölf Einleitungskanäle 164 vorgesehen. Die Einleitungskanäle 164 sind bezüglich der Bohrungen 170 in Längsrichtung des Körpers 120 versetzt angeordnet. Natürlich kann auch eine andere Anzahl von Einleitungskanälen 164 vorgesehen sein. Die Einlasskanäle 164 sind in Längsrichtung des Körpers 120 bevorzugt gleichmäßig beabstandet, wobei eine Dichte im Bereich von 3/100 mm bis 12/100 mm, insbesondere im Bereich von 4/100 mm bis 10/100 mm derzeitig bevorzugt wird, um die Homogenität der Strömung in der Kammer 122 zu fördern.

In der zur Kammer 122 hinweisenden Seite des Wandelements 177 sind zwei Sackbohrungen 178 (siehe Fig. 4) vorgesehen, die jeweils zur Aufnahme eines Abstandshalters 179 (siehe Fig. 3) dienen. Die Abstandshalter 179 sind aus einem geeigneten Material hergestellt, dass bei den eingesetzten Temperaturen und Medien beständig ist und eine gewisse Elastizität aufweist. Insbesondere kann hier auch wieder PFA, wie bei den Stellelementen 134 eingesetzt erden. Die Abstandshalter 179 besitzen jeweils einen nicht dargestellten Fuß zur Aufnahme in einer jeweiligen der Sackbohrungen 178 und einen Kegelstumpfförmigen Hauptteil, der in Fig. 3 zu erkennen ist.

Nachfolgend wird nun der Strahlungsteil 118 dieser Ausführungsform näher erläutert. Der Strahlungsteil 118 weist ein Rohrelement 180 und wenigstens eine Strahlungsquelle 182 auf. Diese besitzen im Wesentlichen denselben Aufbau wie das Rohrelement 30 und die wenigstens eine Strahlungsquelle 32 gemäß der ersten Ausführungsform. Das Rohrelement 180 besitzt eine langgestreckte Form mit einem runden Querschnitt und besteht aus einem für UV-Strahlung im Wesentlichen transparenten Material. Das Rohrelement 180 ist in der Kammer 122 derart aufgenommen, dass es sich über die gesamte Länge erstreckt, und der Mittelpunkt des im Querschnitt runden Rohrelements 180 ist bezüglich des Mittelpunkts des Teilkreises der Innenwand 123 der Kammer 122 in Richtung der Öffnung 121 versetzt. Das runde Rohrelement 180 erstreckt sich wiederum teilweise durch die Öffnung 121 aus dem Gehäuse 114 heraus. Wiederum wird zwischen dem Rohrelement 180 und der Innenwand 123 der Kammer 122 ein Strömungsraum 184 gebildet, der bezüglich einer Längsmittelebene C der Kammer 122, die die Öffnung 121 und die Zuleitungselemente 160 mittig schneidet, symmetrisch ist. Der Strömungsraum 184 bildet einen rechten und einen linken Ast, wie in der Querschnittsansicht gemäß Figur 3 zu erkennen ist. Jeder der Äste besitzt am unteren Ende einen Austrittsschlitz 186. Ausgehend von den Einleitungskanälen 164 zum jeweiligen Austrittsschlitz 186 weist jeder der Äste des Strömungsraums einen sich verjüngenden Strömungsquerschnitt auf. Dieser verjüngt sich in derselben Art und Weise wie bei der ersten Ausführungsform.

Wie in der Ansicht gemäß Figur 3 zu erkennen ist, liegt das Rohrelement 180 auf den Köpfen 136 der jeweiligen Stellelemente 134 auf, und kontaktiert an seiner Oberseite die Abstandshalter 179. Diese sehen somit einen 3-Punkt-Kontakt vor und geben somit die genaue Position des Rohrelements 180 in der Kammer 122 vor. Wie zu erkennen ist, kann über die Stellelemente 134 im gewissen Rahmen die Breite der Austrittsschlitze 186 justiert werden. Die jeweiligen Köpfe 136 der Stellelemente 134 bilden Punktauflagen, welche eine Strömung eines Mediums um die Köpfe herum wenig beeinträchtigen, so dass im Bereich der Austrittsschlitze 186 ein im Wesentlichen kontinuierlicher Medienvorhang gebildet werden kann. Die Strahlungsquelle 132 kann in derselben Art wie bei der ersten Ausführungsform innerhalb des Rohrelements 180 platziert sein.

Der Hauptunterschied zwischen der Ausführungsform des Hauptteils 8 gemäß Figur 2 und der zweiten Ausführungsform des Hauptteils 108 gemäß den Figuren 3 bis 7 liegt im Bereich der Medienführung. Während bei der ersten Ausführungsform über die Zuleitungen 24 ein Medium direkt in die Kammer 122 eingeleitet wird, geschieht dies bei der zweiten Ausführungsform über die Zuleitungselemente 160 in den Medienverteilungskanal 162 und dann über die Einleitungskanäle 164 in die Kammer 122. Hierdurch wird eine gleichmäßigere Verteilung des flüssigen Mediums in Längsrichtung des Körpers 120 erreicht. Im Bereich der Kammer 122 wird somit eine gleichmäßigere Strömung in dem Strömungsraum 184 vorgesehen. Insbesondere in Kombination mit dem sich verjüngenden Querschnitt des Strömungsraums 184 lässt sich an den Austrittsschlitzen 186 eine gleichmäßige Strömung zur Bildung eines gleichmäßigen Flüssigkeitsvorhangs erreichen.

Ein weiterer Unterschied liegt im Bereich der Klammern 150, der Stellelemente 134 und der Abstandshalter 179, die aber in entsprechender Weise auch bei der ersten Ausführungsform vorgesehen sein können. Die Funktion der Klammern 150, die im Bereich der Kammer 122 eine nach innen gerichtete Vorspannung vorsieht, wird anhand der Figuren 8a und 8b näher erläutert. Wenn über die Medienführung 116 ein flüssiges Medium in die Kammer 122 eingeleitet wird, entsteht an den Innenwänden 123 der Kammer ein nach außen gerichteter Druck. Insbesondere im breitesten Bereich der Kammer 122, in dem der Körper 120 einen geringen Querschnitt besitzt kann ein entsprechender Druck zu einer Verformung des Körpers 120 derart führen, dass sich der Abstand an den Austrittsschlitzen 186 vergrößert. Dies gilt insbesondere für einen in Längsrichtung des Körpers 120 mittleren Bereich, da an den Enden die nicht dargestellten Abdeckkappen einer entsprechenden Verformung entgegenwirken würden.

Insbesondere ist in Figur 8a dargestellt, dass sich beispielsweise die Breite des Austrittsschlitzes 186 im mittleren Bereich wesentlich vergrößern kann, wodurch natürlich ein entsprechender Medienaustritt aus dem Austrittsschlitz 186 verändert würde. Dies würde einer gleichmäßigen Medienverteilung entgegenwirken. Durch den Einsatz der Klammern 150 kann dies verhindert werden, wie in Figur 8b dargestellt ist. Die Klammern 150, insbesondere in Kombination mit den Stellelementen 134 können gleichmäßige Breiten der Austrittsschlitze 186 sicherstellen. Die Klammern 150, insbesondere in Kombination mit den Stellelementen 134 können auch unabhängig von einer Veränderung eines Strömungsquerschnitts der Strömungskammer von Vorteil sein, um einen konstante Breite der Austrittsschlitze 186 zu gewährleisten.

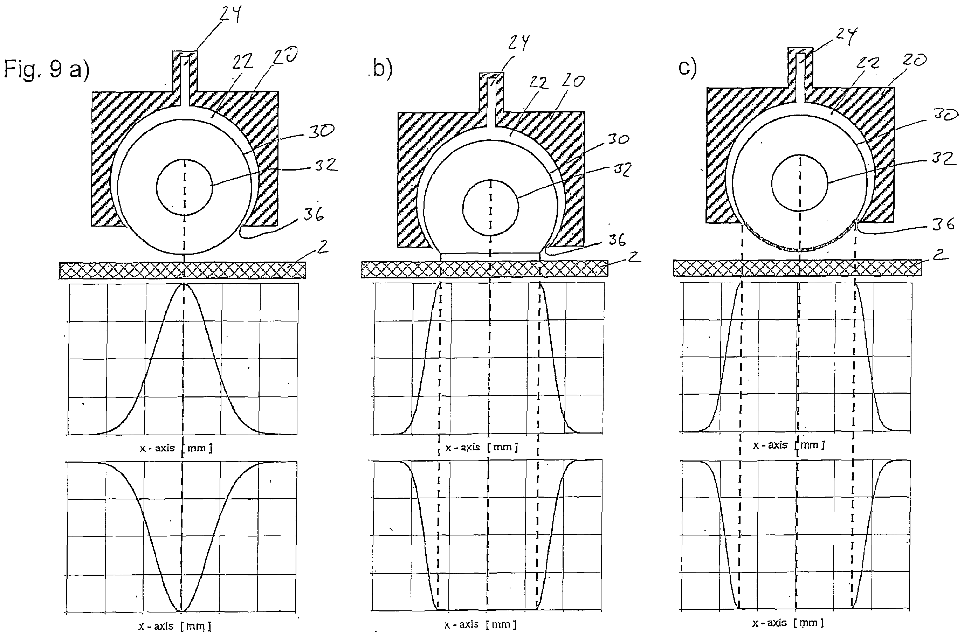

Anhand der Figuren 9 bis 12 werden nunmehr unterschiedliche Konfigurationen des Strahlungsteils 18 gemäß der ersten Ausführungsform näher erläutert. Diese Konfigurationen können aber in gleicher Weise bei der zweiten Ausführungsform eingesetzt werden.

Dabei zeigt Figur 9a eine normale Konfiguration ähnlich Fig. 2 bestehend aus einem im Querschnitt runden Rohrelement 30 mit einer mittig hierzu angeordneten stabförmigen Strahlungsquelle 32. Sofern zweckmäßig werden im Folgenden die gleichen Bezugszeichen, wie bei der ersten Ausführungsform verwendet, wobei die unterschiedlichen Konfigurationen natürlich auch bei der zweiten Ausführungsform eingesetzt werden können.

Das Gehäuse 14 mit Kammer 22 und Zuleitung 24 ist nur schematisch angedeutet. Unterhalb dieser Einheit ist ein Substrat 2 schematisch dargestellt.

Unterhalb der schematischen Darstellung dieser Konfiguration sind zwei Graphen dargestellt, wobei der obere Graph eine Verteilung der Konzentration von Radikalen auf der Oberfläche des Substrats 2 darstellt, wenn ein flüssiges Medium, wie beispielsweise H₂O₂ über die Zuleitung 24 auf das Substrat geleitet wird, und dabei die Strahlungsquelle 32 betrieben wird. Der untere Graph deutet die erreichbare Änderung einer Lackschichtdicke auf dem Substrat bei einem durch die Radikalen geförderten Reinigungsvorgang an, wobei hier eine stationäre Prozessführung vorausgesetzt wird, das heißt die Einheit wird nicht über das Substrat hinweg bewegt, sondern ist stationär. Beide Verteilungen sind in normierter Darstellung aufgetragen.

Wie zunächst zu erkennen ist, hat die Radikalenkonzentration direkte Auswirkung auf die abgetragene Lackschicht. Die Radikalenkonzentration ist im Bereich der Längsmittelebene der Kammer 22 (siehe gestrichelte Linie) am höchsten und fällt nach außen stark ab. Mithin ist die Radikalenkonzentration auf der Oberfläche des Substrats 2 quer zur Kammer 22 stark unterschiedlich. Um einen verbreiteten Bereich mit einer gleichmäßigen (hohen) Radikalenkonzentration vorzusehen, sind unterschiedliche Konfigurationen des Strahlungsteils 18 vorgeschlagen.

So zeigt beispielsweise die Konfiguration gemäß Figur 9b ein Rohrelement 30 mit einer Strahlungsquelle 32. Die Strahlungsquelle 32 entspricht der zuvor beschriebenen. Das Rohrelement 30 hingegen besitzt unterhalb der Öffnung 21 des Hauptkörpers 20 eine Abflachung. Diese ist derart angeordnet, dass sie sich bei einer normalen Ausrichtung horizontal und im Wesentlichen parallel zu einer Unterseite des Hauptkörpers erstreckt. Diese Abflachung ermöglicht eine Anordnung der abgeflachten Unterseite des Rohrelements 30 parallel zur Oberfläche des Substrats 2. Hierdurch wird ein gleichmäßiger Abstand in diesem Bereich gewährleistet. Dieser führt dazu, dass ein gleichmäßiger Flüssigkeitsfilm zwischen Rohrelement 30 und Oberfläche des Substrats 2 gebildet werden kann, und zwar derart, dass sich über die Breite der Abflachung hinweg eine im Wesentlichen gleichmäßige Radikalenkonzentration auf der Oberfläche des Substrats 2 ausbildet. Die Radikalenkonzentration ist in diesem Fall im Wesentlichen proportional zur einfallenden Lichtintensität, welche die Oberfläche des Substrats 2 erreicht.

Entsprechend wird der Bereich mit gleichbleibend hoher Radikalenkonzentration gegenüber der Konfiguration gemäß Figur 9a wesentlich verbreitert und es verbreitert sich auch der Bereich einer hohen Änderung der Lackschichtdicke, was zu einer Verbesserung der Effizienz der Anordnung führt.

Fig. 9c zeigt eine alternative Konfiguration hierzu. Hierbei wird wieder ein Rohrelement 30 mit einem runden Querschnitt eingesetzt. Die Strahlungsquelle 32 ist wiederum dieselbe wie zuvor beschrieben. Das Rohrelement 30 ist derart verändert, dass es in unterschiedlichen Bereichen unterschiedliche Transmissivität besitzt. So weist das Rohrelement 30 in dem innerhalb der Kammer 22 liegenden Bereich eine erste Transmissivität und außerhalb der Kammer 22 eine andere, zweite Transmissivität auf. Insbesondere weist der erste Bereich zum Beispiel eine möglichst hohe Transmissivität gegenüber UV-Strahlung auf, das heißt innerhalb der Strömungskammer kann im wesentlichen die gesamte UV-Strahlung, die durch die Strahlungsquelle 32 zur Verfügung gestellt wird, in die Kammer 22 eingeleitet werden.

Der außerhalb der Kammer liegende Bereich des Rohrelements 30 besitzt hingegen eine geringere Transmissivität, bedingt durch eine erhöhte Absorption oder Reflektion gegenüber UV-Strahlung. Insbesondere besitzt das Rohrelement 30 im Bereich der Längsmittelebene die geringste Transmissivität, und ausgehend von diesem Bereich nimmt die Transmissivität in Richtung der Austrittsschlitze 36 graduell zu. Hierdurch kann die Strahlungsintensität des UV-Lichts in einer Flüssigkeit auf der Oberfläche des Substrats 2 derart eingestellt werden, dass sich über die Breite der Öffnung 21 des Hauptkörpers 20 hinweg eine im wesentlichen gleiche Radikalenkonzentration einstellt, wie in den Graphen gemäß Figur 9c dargestellt ist. Entsprechend wird auch die Breite eines gleichmäßigen hohen Lackdickenabtrags verbreitert.

Ein entsprechender Effekt kann durch das Material des Rohrelements selbst erreicht werden, oder aber auch durch eine Beschichtung oder eine Folie auf oder benachbart zu dem entsprechenden Bereich des Rohrelements. Dabei wäre eine Beschichtung oder Folie bevorzugt innerhalb des Rohrelements anzuordnen, um Verunreinigungen der Flüssigkeit zu vermeiden und ebenso die Beständigkeit der Beschichtung gegenüber den verwendeten Medien vernachlässigen zu können.

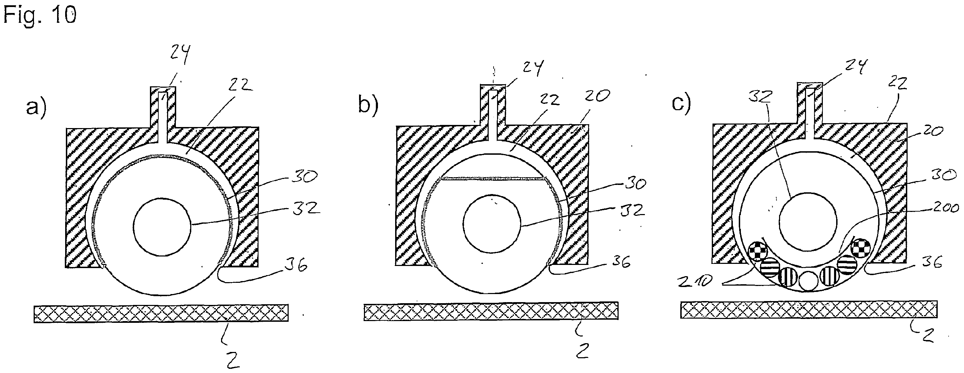

In Fig. 10a bis c sind weitere Konfigurationen des Strahlungsteils 18 gezeigt, wobei jeweils wiederum das Gehäuse 14 mit Kammer 22 und Zuleitung 24 nur schematisch angedeutet ist. Ebenfalls ist wiederum ein Substrat 2 schematisch dargestellt. Graphen wie bei den Figuren 9a bis c sind in Figur 10 nicht dargestellt.

Bei der Konfiguration gemäß Figur 10a ist wiederum eine einzelne Strahlungsquelle 32 vorgesehen, die in einem Rohrelement 30 aufgenommen ist. Bei dieser Konfiguration ist an dem innerhalb der Kammer 22 liegenden Teil des Rohrelements 30 eine Verspiegelung vorgesehen. Diese kann beispielsweise als eine am Rohrelement angebrachte zum Beispiel Innen oder Außen aufgebrachte Schicht oder Folie ausgebildet sein. Diese kann für die von der Strahlungsquelle 32 ausgehende Strahlung voll reflektierend sein oder sie kann auch nur in bestimmten Wellenlängenbereichen reflektierend sein. Dabei ist die Form der Verspiegelung so ausgelegt, dass im Einsatz, das heißt bei einer Medienbeaufschlagung, die von der Strahlungsquelle austretende Strahlung über die Breite der Öffnung 21 hinweg im Wesentlichen gleichmäßig auf das Substrat auftrifft und somit eine im Wesentlichen gleichmäßige Radikalenkonzentration im Medium auf der Substratoberfläche bewirkt. Hierzu muss die aus dem Rohrelement 30 austretende Intensität der Strahlung in den Bereichen benachbart zu den Austrittsschlitzen 36 höher sein als im Bereich der Längsmittelebene C.

Figur 10b zeigt eine weitere Konfiguration einer Verspiegelung, wobei hier eine andere Form der Verspiegelung dargestellt ist, die in einem oberen Bereich flach ist und im Schnitt eine Bogensehne zur runden Form des Rohrelements bildet. Eine solche Form ermöglicht insbesondere im oberen Bereich des Rohrelements 30 (oberhalb der Verspiegelung) das Vorsehen einer weiteren Strahlungsquelle (nicht dargestellt). Diese könnte in einem anderen Spektralbereich emittieren als die Strahlungsquelle 32, um im Bereich des Strömungskanals unterschiedliche Strahlung vorzusehen als im Bereich der Austrittsschlitze 36 und in Richtung des Substrats 2. Neben einer Homogenisierung einer Radikalenkonzentration, könnte hier auch eine Wellenlängenselektion (vorsehen von Strahlung mit unterschiedlichen primären Spektralbereichen in unterschiedlichen Bereichen der Vorrichtung, insbesondere erfindungsgemäß innerhalb der Kammer 22 und außerhalb des Körpers) vorgesehen werden.

Dies könnte auch über selektive Reflektionseigenschaften der Verspiegelung erreicht werden, die beispielsweise UV-Strahlung im Bereich unter 200 nm passieren lässt und oberhalb 200 nm im Wesentlichen reflektiert. Dies gilt natürlich in gleicher Weise für die Ausführungsform gemäß Figur 10a.

In beiden Fällen, das heißt bei der Konfiguration gemäß Figur 10a und 10b, ist es für eine Wellenlängenselektion aber auch möglich innerhalb des Körpers 20 zusätzliche Strahlungsquellen in der Art anzuordnen, dass sie von Außen in die Kammer 22 emittieren. Dabei könnte die in die Kammer 22 emittierte Strahlung insbesondere primär im Bereich unter 200 nm beispielsweise bei ungefähr 185 nm liegen. Die aus der Kammer 22 über die Öffnung 21 herausemittierte Strahlung könnte insbesondere primär im Bereich über 200 nm beispielsweise bei ungefähr 254 nm liegen. Während die Strahlung unter 200 nm primär einer Zersetzung des Mediums im Strömungskanal dienen soll, soll die Strahlung oberhalb der 200 nm primär dazu dienen Radikale zu erzeugen.

Neben einer bestimmten räumlichen Verteilung der Strahlungsintensität könnte bei den obigen Konfigurationen auch leicht eine zusätzliche Wellenlängeselektion vorgenommen werden, die innerhalb der Strömungskammer unterschiedliche Strahlung im Vergleich zu der aus der Kammer heraus in Richtung des Substrats 2 emittierten Strahlung vorsieht.

In ähnlicher Weise ist auch die Ausführungsform gemäß Figur 10c zu sehen. Bei dieser Ausführungsform weist der Strahlenteil 18 wiederum ein Rohrelement 30 auf. Innerhalb des Rohrelements ist eine erste Strahlungsquelle 32 vorgesehen, die des zuvor beschriebenen Typs sein kann. Unterhalb der ersten Strahlungsquelle ist ein konkav nach oben gewölbtes Spiegelelement 200 vorgesehen, das von der Strahlungsquelle 32 ausgehende Strahlung im Wesentlichen zurück nach oben reflektiert. Unterhalb des Spiegelelements 200 ist eine Anordnung unterschiedlicher zweiter Strahlungsquellen 210 vorgesehen. Insbesondere sind sieben Strahlungsquellen 210 dargestellt. Diese emittieren jeweils wenigstens Licht im UV-Bereich, und zwar mit unterschiedlichen Intensitätsverhältnissen. Insbesondere nimmt die Intensität ausgehend von der mittleren der Strahlungsquellen 210 zu den äußeren der Strahlungsquellen 210 kontinuierlich zu. Das heißt die am weitesten außen liegenden Strahlungsquellen 210 emittieren Licht mit der größten Intensität. Bei dieser Konfiguration lässt sich wiederum eine gleichmäßigere Intensitätsverteilung von Licht auf der Substratsoberfläche und somit auch eine gleichmäßigere Radikalenverteilung erreichen.

Insbesondere kann über die Breite der Öffnung 21 des Körpers 20 hinweg eine im Wesentlichen gleichmäßige Radikalerikonzentration mit den zuvor genannten Vorteilen erhalten werden. Darüber hinaus ermöglicht diese Konfiguration auch eine gewisse Wellenlängenselektion derart, dass in den Strömungsraum hinein Strahlung in einem unterschiedlichen Spektralbereich emittieren werden kann, als aus der Öffnung 21 heraus.

Beispielsweise kann die erste Strahlungsquelle wiederum in einem Bereich unter 200 nm, beispielsweise bei ungefähr 185 nm emittieren, während die Strahlungsquellen 210 beispielsweise in einem Bereich oberhalb 200 nm insbesondere bei ungefähr 254 nm emittieren.

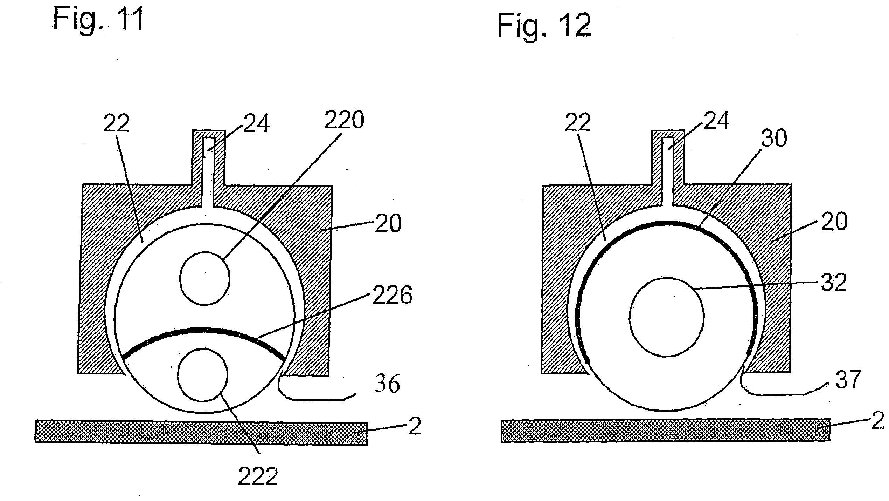

Die Figuren 11 und 12 zeigen noch weitere Konfigurationen des Strahlungsteils 18. Wiederum sind der Körper 20 mit der Kammer 22 und der Öffnung 21 sowie ein Substrat 2 schematisch dargestellt.

Der Strahlungsteil 18 bei der Konfiguration gemäß Fig. 11 weist wiederum ein Rohrelement 30 auf, das im Wesentlichen für UV-Strahlung transparent ist. Innerhalb des Rohrelements 30 sind zwei Strahlungsquellen 220 und 222 dargestellt. Die zwei Strahlungsquellen 220, 222 sind innerhalb des Rohrelements 30 übereinander angeordnet. Die Strahlungsquellen 220, 222 sind unterschiedlicher Art, und emittieren insbesondere in unterschiedlichen Spektralbereichen. Dabei imitiert beispielsweise die obere Strahlungsquelle 220 primär in einem Spektralbereich unter 200 nm, beispielsweise bei 185 nm emittiert, während die untere Strahlungsquelle 222 primär in einem Spektralbereich über 200 nm, beispielsweise bei 254 nm, emittiert.

Zwischen den Strahlungsquellen 220 und 222 ist ein gebogener Reflektor 226 vorgesehen, der beidseitig reflektierend ist. Der Reflektor bewirkt im Wesentlichen eine Trennung der Strahlung, die in den Strömungsraum hinein imitiert wird von der Strahlung die aus der Öffnung 21 heraus imitiert wird. Dabei ist der Reflektor 226 so angeordnet, dass in den Endbereich der jeweiligen Strömungskanäle - benachbart zu den Austrittsschlitzen 36 - Strahlung sowohl von der oberen Strahlungsquelle 220 als auch der unteren Strahlungsquelle 222 emittiert wird.

Während die Strahlung unter 200 nm, wie oben erwähnt, primär im Wesentlichen zu einer Zersetzung des Mediums im Strömungskanal führen soll, dient die Strahlung oberhalb 200 nm dazu, Radikale zu erzeugen. Da eine entsprechende Erzeugung möglichst auch schon im Endbereich des Strömungskanals gewünscht ist, ist die dargestellte Konfiguration vorteilhaft. Die Krümmung des nach unten weisenden Bereichs des Reflektors 126 kann dabei speziell so gewählt sein, dass sich wiederum eine möglichst homogene Intensitätsverteilung der Strahlung auf dem Substrat ergibt, wie zuvor beschrieben.

Bei der Ausführungsform gemäß Figur 12 ist wiederum ein Rohrelement 30 mit einer einzelnen Strahlungsquelle 32 vorgesehen. Das Rohrelement 30 besitzt wiederum unterschiedliche Absorptionseigenschaften innerhalb der Kammer 22 und außerhalb der Kammer 22. Insbesondere ist der außerhalb der Kammer liegende Bereich des Rohrelements 30 im Wesentlichen für UV-Strahlung transparent, während der innerhalb der Kammer 22 liegende Bereich des Rohrelements 30 einen wesentlichen Anteil der UV-Strahlungen absorbiert. Insbesondere sind die Absorptionseigenschaften des innerhalb der Kammer 22 liegenden Bereichs so eingestellt, dass primär UV-Strahlung im Bereich über 200 nm absorbiert wird. Wie in der Darstellung gemäß Figur 12 zu erkennen ist, erstreckt sie der im Wesentlichen transparente Bereich zum Teil in die Kammer 22 hinein, sodass wie zuvor erwähnt UV-Strahlung oberhalb 200 nm auch in die Endbereiche der Kammer 22 benachbart zu den Austrittsschlitzen emittiert wird, um schon hier eine gewünschte Radikalenerzeugung vorzusehen.

Ein entsprechender Überlapp zwischen den Endbereichen der Kammer 22 und dem transparente Bereich des Rohrelements 30 kann jeweils in einem Winkelbereich von bis zu 20° vom Mittelpunkt des Rohrelements aus gesehen gegeben sein (Mithin ein gemeinsamer Überlapp der Endbereiche von bis zu 40°). Dies gilt nicht nur für diese Ausführungsform sondern auch für die Anderen, bei denen selektiv Strahlung unterschiedliche Wellenlängen in den Strömungskanal hinein und aus dem Gehäuse heraus emittiert werden soll. Obwohl dies nicht konkret dargestellt ist, können zusätzliche Mittel vorgesehen sein, die bewirken, dass in einem dritten Bereich des Rohrelements, der zum Strömungsraum weist, keine UV-Strahlung in den Strömungsraum emittiert wird. Beispielsweise können die zweiten Mittel ein für UV-Strahlung opakes Element zwischen der wenigstens einen Strahlungsquelle und dem Strömungsraum aufweisen. Der dritte Abschnitt würde bevorzugt zur wenigstens einen Einlassöffnung weisen und zur Längsmittelebene symmetrisch angeordnet sein und sich in Umfangsrichtung des Rohrelements über nicht mehr als 60° erstrecken.

Nachfolgend wird nunmehr der Betrieb der Vorrichtung 1 näher erläutert. Dabei wird zunächst von der Konfiguration gemäß den Figuren 1 und 2 ausgegangen. Der Betriebsablauf verändert sich aber für die unterschiedlichen Ausführungsformen nicht.

Die Auftragseinheit 6, insbesondere der Hauptteil 8 wird in eine Position benachbart zu einem Substrat 2 gebracht, in der aus der Öffnung 21 austretende Flüssigkeit nicht auf das Substrat 2 gelangt. Über die Medienanschlüsse 16 wird flüssiges Medium, wie beispielsweise verdünntes Wasserstoffperoxydwasser oder Ozonwasser O₃-H₂O in die Kammer 22 eingeleitet, während gleichzeitig die Strahlungsquelle 32 eingeschaltet ist.

In der Strömungskammer zwischen Rohrelement 36 und Innenwand 23 der Kammer 22 baut sich eine Flüssigkeitsströmung auf, die in Richtung der Austrittsschlitze 36 beschleunigt wird. Insbesondere wird die Geschwindigkeit der Flüssigkeit ausgehend von einem oben liegenden Bereich am Ende der Zuleitung 24 bis zu den Austrittsschlitzen um einen Faktor 10:1 bis 40:1 und bevorzugt im Bereich 15:1 bis 25:1, durch eine entsprechende Querschnittsänderung beschleunigt.

Unterhalb des Hauptteils 8 bildet sich ein Wasservorhang aus, der sich gleichmäßig über einen wesentlichen Teil der Länge des Hauptteils 8 erstreckt. Durch die von der Strahlungsquelle 32 emittierte Strahlung wird die Flüssigkeit in dem Strömungskanal, das heißt zwischen dem Zulauf 24 und den Austrittsschlitzen 36, zersetzt, um unerwünschte reaktive Spezies innerhalb der Flüssigkeit zu zerstören. Gleichzeitig werden durch die Strahlung Radikale erzeugt. Diese Mechanismen finden primär bei unterschiedlichen Spektralbereichen der Strahlung statt. So ist für eine Zersetzung eine Strahlung in einem Spektralbereich unter 200 nm von Vorteil, während für eine Radikalenerzeugung eine Strahlung oberhalb von 200 nm, insbesondere bei ungefähr 254 nm, gewünscht ist. Ohne spezielle Maßnahme, wie sie in den Figuren 9 bis 11 beschrieben sind, ist die von der Strahlungsquelle 32 ausgehende Strahlung im Bereich des Strömungskanals und außerhalb des Körpers 20 im Wesentliche gleich und enthält in der Regel Strahlungsanteile sowohl über als auch unter 200 nm. Durch die Beschleunigungsströmung im Strömungskanal wird eine Homogenisierung der Strömung erreicht und somit der Flüssigkeitsvorhang über eine große Breite homogen ausgebildet.

Wie beschrieben, wird in dem Strömungskanal einerseits die Flüssigkeit zersetzt und unerwünschte reaktive Spezies aufgebrochen, während gleichzeitig Radikale, insbesondere Hydroxyl-Radikale, erzeugt werden. Diese werden insbesondere auch im Bereich der Austrittsschlitze 36 erzeugt, so dass diese ausreichend lange bestehen können, um auf die Oberfläche des Substrats 2 zu gelangen, wenn nun der Hauptteil 8 der Auftragseinheit 6 über das Substrat 2 hinweg bewegt wird.

Das Substrat 2 kann beispielsweise eine Photomaske sein, von der Lackreste abgereinigt werden muss. Eine solche Reinigung kann ganzflächig oder auch nur in bestimmten Bereichen der Maske erfolgen. Durch eine Bewegung des Hauptteils 8 der Auftragseinheit 6 über das Substrat hinweg, wird der Flüssigkeitsvorhang über das Substrat 2 bewegt. Durch die Strahlungsquelle 32 werden innerhalb der Flüssigkeit kontinuierlich weiterhin Radikale erzeugt, wobei eine entsprechende Radikalenerzeugung insbesondere im Bereich der Austrittsschlitze und unterhalb der Öffnung 21 im Körper 20 von Bedeutung ist und ggf. durch bestimmte Maßnahmen, wie in den Ausführungsformen beschrieben, hier konzentriert wird. Somit ist die Flüssigkeit unterhalb der Öffnung 21 mit Radikalen aufgeladen und für eine Lackreinigung besonders wirksam. Da die Radikale rasch zerfallen, ist die Flüssigkeit in Bereichen, die nicht unterhalb der Öffnung 21 liegen, nicht mehr so wirksam.

Die Geschwindigkeit des Überstreichens kann auf das erforderliche Reinigungsergebnis abgestimmt werden, um ausreichend lange Verweilzeiten der mit Radikalen aufgeladenen Flüssigkeit auf dem Substrat zu erreichen. Wenn die Maske entsprechend gereinigt ist, kann entweder die Medienzufuhr gestoppt und die Strahlungsquelle abgeschaltet werden, oder es kann ein nächstes Substrat 2 in der entsprechenden Weise behandelt werden.

Die Erfindung wurde zuvor anhand bevorzugter Ausführungsformen der Erfindung näher erläutert, ohne auf die konkreten Ausführungsformen beschränkt zu sein. Insbesondere können die unterschiedlichen Merkmale der Ausführungsformen frei miteinander kombiniert oder ausgetauscht werden, sofern entsprechende Kompatibilität gegeben ist. Insbesondere sei auch erwähnt, dass die Kombination aus Vorspannelementen und Abstandsstiften auch unabhängig von einer Veränderung eines Strömungsquerschnitts des Strömungsraums von Vorteil sein kann, um einen Konstante Breite der Austrittsschlitze zu gewährleisten.

## Patentansprüche

1. Vorrichtung zum Aufbringen eines mit UV-Strahlung beaufschlagten flüssigen Mediums auf ein Substrat, die Folgendes aufweist:
ein Gehäuse (14, 114), mit einer langgestreckten Kammer (22, 122), wenigstens einer Einlassöffnung, die sich zur Kammer hin öffnet und einer der wenigstens einen Einlassöffnung gegenüberliegenden, schlitzförmigen Auslassöffnung (21), die sich über die Länge der Kammer erstreckt;
ein sich in Längsrichtung durch die Kammer erstreckendes Rohrelement (30), das wenigstens teilweise für UV-Strahlung transparent ist, wobei das Rohrelement derart in der Kammer angeordnet ist, dass zwischen dem Rohrelement und der Wand der Kammer ein Strömungsraum (184) gebildet wird, der bezüglich einer Längsmittelebene der Kammer, die die Auslassöffnung mittig schneidet,
symmetrisch ist, und dass sich das Rohrelement in die schlitzförmige Auslassöffnung im Gehäuse erstreckt und dabei zwei in Längsrichtung erstreckende Austrittsschlitze (37, 186) zwischen Rohrelement und Gehäuse bildet; und
wenigstens eine UV-Strahlungsquelle (32, 132, 210, 220, 222) im Rohrelement, die angeordnet ist, um UV-Strahlung in Richtung des Strömungsraumes und durch die Auslassöffnung aus dem Gehäuse heraus zu emittieren;
**gekennzeichnet durch**
Mittel (200, 226) zum Bewirken, dass UV-Strahlung primär in einem ersten Wellenlängenbereich durch einen ersten Abschnitt des Rohrelements in den Strömungsraum emittiert wird und dass UV-Strahlung primär in einem zweiten Wellenlängenbereich durch einen zweiten Abschnitt des Rohrelements durch die Auslassöffnung (21) des Gehäuses emittiert wird, wobei der zweite Abschnitt von einem Mittelpunkt des Rohrelements aus gesehen wenigstens einen Winkelbereich abdeckt, der einem vom Mittelpunkt des Rohrelements aus gesehenem Winkelbereich der schlitzförmigen Auslassöffnung im Gehäuse entspricht, wobei sich die ersten und zweiten Wellenlängenbereiche unterscheiden und wobei für wenigstens den zweiten Abschnitt gilt, dass maximal 20%, bevorzugt maximal 5% der durch den zweiten Abschnitt emittierten Strahlungsleistung aus dem ersten Wellenlängenbereich stammt.

2. Vorrichtung nach Anspruch 1, wobei die Mittel verschiedene Materialien mit unterschiedlichen Transmissionseigenschaften für die jeweiligen Wellenlängenbereiche aufweisen, die die Transmissionseigenschaften der ersten und zweiten Abschnitte des Rohrelements beeinflussen.

3. Vorrichtung nach Anspruch 1 oder 2, wobei die Mittel wenigstens zwei unterschiedliche UV-Strahlungsquellen und wenigstens ein Trennelement in dem Rohrelement, das zwischen den unterschiedlichen UV-Strahlungsquellen angeordnet ist, aufweisen, wobei wenigstens eine erste Strahlungsquelle Strahlung primär im ersten Wellenlängenbereich und wenigstens eine zweite Strahlungsquelle Strahlung primär im zweiten Wellenlängenbereich emittiert.

4. Vorrichtung nach Anspruch 3, wobei sich das Trennelement im Wesentlichen über die gesamte Breite des Rohrelements erstreckt und die Enden des Trennelements eine Trennung zwischen den ersten und zweiten Abschnitten des Rohrelements definieren.

5. Vorrichtung nach Anspruch 3 oder 4, wobei die den jeweiligen Strahlungsquellen zugewandten Oberflächen des Trennelements wenigstens teilweise spiegelnd ausgebildet sind und insbesondere in dem jeweiligen primären Emissionsbereich der zugewandten Strahlungsquelle spiegelnd sind.

6. Vorrichtung nach einem der Ansprüche 3 bis 5, wobei wenigstens eine einer jeweiligen Strahlungsquellen zugewandte Oberfläche des Trennelements gebogen ist, um an der Oberfläche reflektierte Strahlung in einem bestimmten Muster zu verteilen.

7. Vorrichtung nach Anspruch 6, wobei die der ersten Strahlungsquelle zugewandte Oberfläche des Trennelements konvex gebogen ist und/oder die der zweiten Strahlungsquelle zugewandte Oberfläche wenigstens einen konkav gebogenen Abschnitt aufweist.

8. Vorrichtung nach einem der vorhergehenden Ansprüche, wobei die Mittel im Rohrelement und benachbart zu oder in Kontakt mit wenigstens einem Abschnitt des Rohrelements ein Filterelement aufweisen, das selektiv UV-Strahlung im gewünschten Wellenlängenbereich durchlässt und Strahlung außerhalb des gewünschten Wellenlängenbereichs absorbiert.

9. Vorrichtung nach einem der vorhergehenden Ansprüche, wobei der erste Wellenlängenbereich im Bereich von <200 nm und der zweite Wellenlängenbereich im Bereich von > 220 nm liegt.

10. Vorrichtung nach einem der vorhergehenden Ansprüche, die ferner zweite Mittel aufweist, die bewirken, dass in einem dritten Abschnitt des Rohrelements, der zum Strömungsraum weist, keine UV-Strahlung in den Strömungsraum emittiert wird.

11. Vorrichtung nach Anspruch 10, wobei die zweiten Mittel ein für UV-Strahlung opakes Element zwischen der wenigstens einen Strahlungsquelle und dem Strömungsraum aufweisen.

12. Vorrichtung nach Anspruch 10 oder 11, wobei der dritte Abschnitt zur wenigstens einen Einlassöffnung weist und zur Längsmittelebene symmetrisch angeordnet ist.

13. Vorrichtung nach Anspruch 12, wobei sich der dritte Abschnitt in Umfangsrichtung des Rohrelements bis maximal 5° vor die entsprechenden Austrittsschlitze erstreckt.

14. Vorrichtung nach einem der vorhergehenden Ansprüche, wobei der zweite Abschnitt den Strömungsraum entlang des Strömungsweges zwischen der wenigstens einen Einlassöffnung und dem jeweiligen Austrittsschlitz höchstens im letzten Viertel, überlappt.

15. Vorrichtung nach einem der vorhergehenden Ansprüche, wobei der zweite Abschnitt einen Winkelbereich abdeckt, der bis maximal 40° größer ist als der vom Mittelpunkt des Rohrelements aus gesehenem Winkelbereich der schlitzförmigen Öffnung im Gehäuse.

## Claims

1. An apparatus for applying a liquid medium irradiated with UV radiation onto a substrate, the apparatus comprising:
a housing (14, 114) having an elongated chamber (22, 122), at least one inlet opening, which opens into the chamber, and at least one slit shaped outlet opening (21) opposite the inlet opening, which extends over the length of the chamber;
a tube element (30), which extends in a longitudinal direction through the chamber, the tube element being at least partially transparent to UV radiation, wherein the tube element is arranged in the chamber such that a flow space (184) is formed between the tube element and the wall of the chamber, the flow space being symmetric with respect to a longitudinal centre plane of the chamber, the longitudinal centre plane dissecting the outlet opening in its middle, and such that the tube element extends into the slit shaped outlet opening in the housing and thereby forms two longitudinally extending outlet slits (37, 186) between the tube element and the housing; and
at least one UV-radiation source (32, 132, 210, 220, 222) in the tube element, which is arranged to emit UV-radiation in the direction of the flow space and through the outlet opening out of the housing;
**characterized by**:
means (200, 226) for causing UV radiation to be emitted primarily in a first wavelength range through a first section of the tube element into the flow space and for causing UV radiation to be emitted primarily in a second wavelength range through a second section of the tube element through the outlet opening (21) of the housing, wherein the second section as seen from a center point of the tube element covers at least an angular region corresponding to an angular region of the slit shaped opening in the housing as seen from the center point of the tube element, wherein the first and second wavelength ranges differ, and wherein for at least the second section, a maximum of 20%, preferably a maximum of 5%, of the radiation power emitted through the second section comes from the first wavelength range.

2. The apparatus according to claim 1, wherein the means comprise different materials with different transmission characteristics for the respective wavelength ranges which influence the transmission characteristics of the first and second sections of the tube element.

3. The apparatus according to claim 1 or 2, wherein the means comprise at least two different UV radiation sources and at least one separating element in the tube element arranged between the different UV radiation sources, wherein at least one first radiation source emits radiation primarily in the first wavelength range and at least one second radiation source remits radiation primarily in the second wavelength range.

4. The apparatus according to claim 3, wherein the separating element extends substantially across the entire width of the tube member and the ends of the separating element define a separation between the first and second sections of the tube element.

5. The apparatus according to claim 3 or 4, wherein the surfaces of the separating element facing the respective radiation sources are formed to be at least partially reflective and are in particular reflective with respect to the primary emission wavelength of the radiation source they are facing.

6. The apparatus according to one of claims 3 to 5, wherein at least one surface of the separating element facing a respective radiation source is curved in order to distribute radiation reflected on the surface in a specific pattern.

7. The apparatus according to claim 6, wherein the surface of the separating element facing the first radiation source is convexly curved and/or wherein the surface facing the second radiation source has at least one concavely curved section.

8. The apparatus according to any one of the preceding claims, wherein the means in the tube member and adjacent to or in contact with at least a portion of the tube element comprise a filter element which selectively transmits UV radiation in the desired wavelength range and absorbs radiation outside the desired wavelength range.

9. The apparatus according to one of the preceding claims, wherein the first wavelength range in the range of <200 nm and the second wavelength range in the range of >220 nm.

10. The apparatus according to one of the preceding claims, further comprising second means, which cause that in a third section of the tube element, which faces the flow space, no UV radiation is emitted into the flow space.

11. The apparatus of claim 10, wherein the second means comprises an element which is opaque to UV radiation and which is arranged between the at least one radiation source and the flow space.

12. The apparatus according to claim 10 or 11, wherein the third section faces towards the at least one inlet opening and is arranged symmetrically with respect to the longitudinal center plane.

13. The apparatus according to claim 12, wherein the third section extends in the circumferential direction of the tube element up to at most 5° before the respective outlet slits.

14. The apparatus according to one of the preceding claims, wherein the second section overlaps the flow space along the flow path between the at least one inlet opening and the respective outlet slit at most in the last quarter thereof.

15. The apparatus according to one of the preceding claims, wherein the second section covers an angular region which is at most 40° greater than the angular region of the slit shaped opening in the housing as seen from the center point of the tube element.

## Revendications

1. Appareil pour appliquer un milieu liquide exposé à un rayonnement UV sur un substrat, l'appareil comprenant :
un boîtier (14, 114) ayant une chambre allongée (22, 122), au moins une ouverture d'entrée, qui s'ouvre dans la chambre, et au moins une ouverture de sortie en forme de fente (21), à l'opposé de l'ouverture d'entrée, qui s'étend sur la longueur de la chambre ;
un élément de tube (30), qui s'étend dans une direction longitudinale à travers la chambre, l'élément de tube étant au moins partiellement transparent au rayonnement UV, dans lequel l'élément de tube est agencé dans la chambre de sorte qu'un espace d'écoulement (184) soit formé entre l'élément de tube et la paroi de la chambre, l'espace d'écoulement étant symétrique par rapport à un plan central longitudinal de la chambre, le plan central longitudinal de la chambre coupant l'ouverture de sortie en son milieu, et de sorte que l'élément de tube s'étende dans l'ouverture de sortie en forme de fente dans le boîtier et forme ainsi deux fentes de sortie s'étendant longitudinalement (37, 186) entre l'élément de tube et le boîtier ; et
au moins une source de rayonnement UV (32, 132, 210, 220, 222) dans l'élément de tube, qui est agencée pour émettre un rayonnement UV dans la direction de l'espace d'écoulement et à travers l'ouverture de sortie sortant du boîtier ;
**caractérisé par** :
des moyens (200, 226) pour forcer le rayonnement UV à être émis principalement dans une première plage de longueurs d'onde à travers une première section de l'élément de tube dans l'espace d'écoulement et pour forcer le rayonnement UV à être émis principalement dans une deuxième plage de longueurs d'onde à travers une deuxième section de l'élément de tube à travers l'ouverture de sortie (21) du boîtier, dans lequel la deuxième section vue depuis un point central de l'élément de tube couvre au moins une région angulaire correspondant à une région angulaire de l'ouverture en forme de fente dans le boîtier vue depuis le point central de l'élément de tube, dans lequel les première et deuxième plages de longueurs d'onde sont différentes, et dans lequel, pour au moins la deuxième section, un maximum de 20 %, de préférence un maximum de 5 %, de la puissance de rayonnement émise à travers la deuxième section provient de la première plage de longueurs d'onde.

2. Appareil selon la revendication 1, dans lequel les moyens comprennent différents matériaux ayant différentes caractéristiques d'émission pour les plages de longueurs d'onde respectives qui influencent les caractéristiques d'émission des première et deuxième sections de l'élément de tube.

3. Appareil selon la revendication 1 ou 2, dans lequel les moyens comprennent au moins deux sources différentes de rayonnement UV et au moins un élément de séparation dans l'élément de tube, qui est agencé entre les sources différentes de rayonnement UV, dans lequel au moins une première source de rayonnement irradie principalement dans la première plage de longueurs d'onde et au moins une deuxième source de rayonnement ré-émet principalement dans la deuxième plage de longueurs d'onde.

4. Appareil selon la revendication 3, dans lequel l'élément de séparation s'étend sensiblement sur toute la largeur de l'élément de tube et les extrémités de l'élément de séparation définissent une séparation entre les première et deuxièmes sections de l'élément de tube.

5. Appareil selon la revendication 3 ou 4, dans lequel les surfaces de l'élément de séparation faisant face aux sources de rayonnement respectives sont formées pour être au moins partiellement réfléchissantes et sont en particulier réfléchissante s'agissant de la longueur d'onde d'émission primaire de la source de rayonnement à laquelle elles font face.

6. Appareil selon l'une quelconque des revendications 3 à 5, dans lequel au moins une surface de l'élément de séparation faisant face à une source de rayonnement respective est incurvée pour répartir le rayonnement réfléchi sur la surface selon un motif spécifique.

7. Appareil selon la revendication 6, dans lequel la surface de l'élément de séparation faisant face à la première source de rayonnement est incurvée de façon convexe et/ou dans lequel la surface faisant face à la deuxième source de rayonnement a au moins une section incurvée de façon concave.

8. Appareil selon l'une quelconque des revendications précédentes, dans lequel les moyens dans l'élément de tube et adjacents à ou en contact avec au moins une partie de l'élément de tube comprennent un élément de filtre qui transmet sélectivement le rayonnement UV dans la plage de longueurs d'onde souhaitée et absorbe le rayonnement en dehors de la plage de longueurs d'onde souhaitée.

9. Appareil selon l'une quelconque des revendications précédentes, dans lequel la première plage de longueurs d'ondes est dans la plage < 200 nm et la deuxième plage de longueurs d'ondes dans la plage > 220 nm.

10. Appareil selon l'une quelconque des revendications précédentes, comprenant en outre des deuxièmes moyens, qui forcent que, dans une troisième section de l'élément de tube, qui fait face à l'espace d'écoulement, aucun rayonnement UV n'est émis dans l'espace d'écoulement.

11. Appareil selon la revendication 10, dans lequel les deuxièmes moyens comprennent un élément qui est opaque au rayonnement UV et qui est agencé entre ladite au moins une source de rayonnement et l'espace d'écoulement.

12. Appareil selon la revendication 10 ou 11, dans lequel la troisième section fait face à ladite au moins une ouverture d'entrée et est agencée symétriquement par rapport au plan central longitudinal.

13. Appareil selon la revendication 12, dans lequel la troisième section s'étend dans la direction circonférentielle de l'élément de tube jusqu'à un maximum de 5° devant les fentes de sortie respectives.

14. Appareil selon l'une quelconque des revendications précédentes, dans lequel la deuxième section recouvre l'espace d'écoulement le long du trajet d'écoulement entre ladite au moins une ouverture d'entrée et la fente de sortie respective au plus dans son dernier quart.

15. Appareil selon l'une quelconque des revendications précédentes, dans lequel la deuxième section recouvre une plage angulaire qui est au plus de 40° supérieure à la région angulaire de l'ouverture en forme de fente dans le boîtier vue depuis le point central de l'élément de tube.
